# EUROPEAN PATENT APPLICATION

(11) **EP 2 661 156 A1**
(43) Date of publication of application: **06.11.2013**
(21) Application number: 11853717.4
(22) Date of filing: 16.12.2011
(51) Int. Cl.: H05K 1/02, H01L 23/13, H01L 23/36, H05K 1/03

(54) **CIRCUIT BOARD FOR SEMICONDUCTOR MODULE**

(30) Priority: 28.12.2010 JP 2010291538
(71) Applicant: Hitachi, Ltd., Tokyo 100-8280 (JP)
(72) Inventor: ANDO, Takashi, Hitachi-shi, Ibaraki 319-1292 (JP); MORITA, Toshiaki, Hitachi-shi, Ibaraki 319-1292 (JP); IDE, Eiichi, Hitachi-shi, Ibaraki 319-1292 (JP); YASUDA, Yusuke, Hitachi-shi, Ibaraki 319-1292 (JP)
(74) Representative: MERH-IP Matias Erny Reichl Hoffmann
(86) International application number: PCT/JP2011/079256
(87) International publication number: WO 2012/090740

(57) **Abstract**

An object of the invention is to provide a circuit board that is provided for a semiconductor module, simplifies constituent members, reduces warpage, caused by temperature cycles under a high temperature condition, of the circuit board, and has an excellent bonding reliability of a bonding portion and an excellent heat dissipation property.

The circuit board includes a holding member, a bonding layer, an insulating substrate, a bonding layer, and a circuit wiring board, which are sequentially stacked in this order. The bonding layers are sintered bodies containing metal, the insulating substrate is made of non-oxide ceramic, and oxide layers are formed on both surfaces of the insulating substrate.

## Description

### Technical Field

The present invention relates to a ceramic circuit board that is applied to a power semiconductor module or the like.

### Background Art

In a semiconductor device typified by a power module, all electrodes are electrically insulated from a metal holding member and are insulated by an insulation member from all package members including the metal holding member and drawn to the outside. Thus, even if a pair of main electrodes is isolated from a ground potential on a circuit, a package can be fixed to a ground potential portion regardless of electrode potentials, and thereby the semiconductor device is easily installed.

For the semiconductor device, it is necessary to efficiently dissipate heat generated upon an operation of the device to the outside of the package in order to safely, stably operate a semiconductor element stored in the device. Normally, the heat dissipation is achieved by transmitting the heat from a semiconductor element substrate that is a source of the heat into air through members coupled with the semiconductor element substrate. In general, the semiconductor device includes, in a heat transmission path, an insulating body, a bonding layer used for a part or the like to bond the semiconductor substrate, and the metal holding member.

In addition, the higher power to be used for a circuit including the semiconductor device, or the higher a required reliability (time-dependent stability, humidity resistance, heat resistance, and the like), the higher an insulation property is required. The heat resistance includes heat resistance for the case where the ambient temperature of the semiconductor device increases due to an external cause and heat resistance for the case where the amount of power used for the semiconductor device is large and the amount of heat generated by the semiconductor substrate is large.

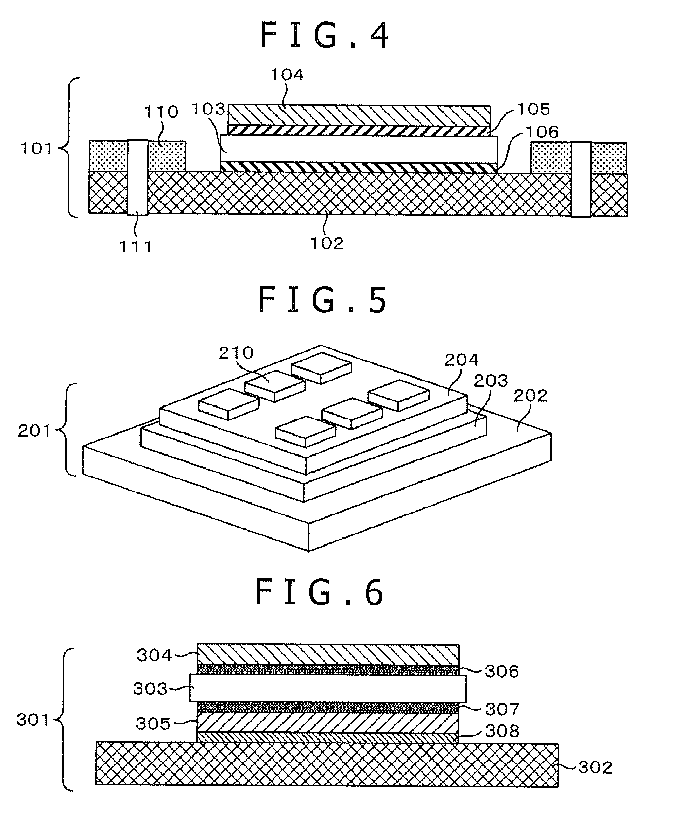

Since a certain organized electric circuit that includes a semiconductor element substrate is embedded in an insulation type semiconductor device in general, it is necessary to electrically insulate at least a part of the circuit from a metal holding member. As an example, the configuration of a board that includes a known semiconductor element substrate is illustrated in Fig. 6. An insulating circuit member is configured by bonding circuit wiring boards 304 and 305 to front and back surfaces of an insulating substrate 303 through bonding layers 306 and 307. In addition, the circuit board 301 in which the circuit wiring board 304 is electrically insulated from a holding member 302 is configured by bonding the insulating circuit member to the holding member 302 through a solder layer 308. Here, the circuit wiring boards 304 and 305 are made of a metal material that has excellent electric conductivity, such as copper or aluminum. In addition, the insulating substrate 303 is made of a ceramic material that is resistant to a high voltage, such as alumina, aluminum nitride or silicon nitride. Further, the holding member 302 is made of a material that has an excellent heat dissipation property, such as aluminum-silicon carbide (AlSiC) or copper. In addition, the circuit wiring boards 304 and 305 that are bonded to the front and back surfaces of the insulating substrate 303 have a role as cushioning materials for reducing the amount of warpage of the insulating circuit member. Further, silver blazing filler metal is usually used for the bonding layers 306 and 307 arranged between the ceramic insulating substrate 303 and the metal circuit wiring boards 304 and 305.

A thermal expansion coefficient of a ceramic material is different from that of a metal material. A thermal expansion coefficient of the ceramic material used for the semiconductor device is lower than 10 × 10⁻⁶ /°C, while that of the metal material is in a range of 10 × 10⁻⁶ /°C to 20 × 10⁻⁶ /°C. Thus, when the circuit board is exposed to a high temperature in a process of bonding the insulating circuit member to the holding member, or the ambient temperature of the semiconductor device changes, the circuit board may be warped or stress may be applied to the circuit board, thereby damaging a bonded part or a member.

To reduce the warpage and stress of the board which are caused by the change in the ambient temperature, there is known a method for configuring the holding member made of a material having a thermal expansion coefficient close to the insulating substrate. For example, since the ceramic substrate used for the insulating substrate has a low thermal expansion coefficient (of approximately 3 × 10⁻⁶ /°C to 8 × 10⁻⁶ /°C), aluminum-silicon carbide (with a linear expansion coefficient of approximately 7.5 × 10⁻⁶ /°C) that is a composite material with a low thermal expansion coefficient is used for the holding member.

In addition, a structure that has a reduced number of members and a reduced number of bonding layers has been proposed in order to efficiently dissipate heat generated by a semiconductor substrate. As an example, there has been proposed a structure in which a holding member is directly bonded to a back surface of an insulating substrate and from which a single circuit wiring board and a solder layer are removed. Silver blazing filler metal with excellent thermal conductivity is used to bond the back surface of the insulating substrate to the holding member. Since the temperature of the silver blazing filler metal upon the bonding, however, is high (approximately 800°C), it is necessary to select a metal holding member and a wiring board member that do not dissolve upon the bonding.

In addition, as a structure that has a reduced number of members and a reduced number of bonding layers, a structure in which a holding member made of metal is directly bonded to a back surface of an insulating substrate made of ceramic without a bonding material has been proposed in Patent Documents 1 and 2. In order to bond the holding member to the back surface of the insulating substrate, a molten metal method for contacting dissolved metal with ceramic, cooling them, and thereby forming a bonding material is used. In this method, however, a bonding layer and a stress absorbing layer are not provided, and whereby stress applied between the metal and the ceramic is directly applied to the ceramic. In order to reduce the stress, it is necessary to select a low-melting-point metal material such as aluminum.

On the other hand, Patent Documents 3 and 4 each disclose a bonding material for which metal particles with diameters of 100 nm or less are used. Since the metal particles are used, sintering at a lower temperature than the melting point of metal and bonding at a lower temperature (of 400°C or lower) than conventional blazing filler metal can be achieved. Particularly, the metal particles are bonded to the metal in metallic bonding, and joint strength that is equal to or higher than that obtained when conventional blazing filler metal, solder, or the like is used can be obtained.

### Prior Art Documents

### Patent Documents

Patent Document 1: JP-2003-258150-A
Patent Document 2: JP-2008-283210-A
Patent Document 3: JP-2006-228804-A
Patent Document 4: JP-2008-161907-A

### Summary of the Invention

### Problems to be Solved by the Invention

Patent Document 3 describes that a paste material obtained by mixing a volatile organic solvent with metal particles is sintered in a state of being inserted in an irregular portion of a ceramic surface, and the metal particles are bonded to the ceramic surface by an anchor effect. When the paste material is inserted in the irregular portion of the ceramic surface, the organic solvent contained in the paste material is also inserted in the irregular portion. If the organic solvent remains in the irregular portion after a heat treatment, it is expected that the remaining organic solvent inhibits the metal particles from being inserted in the irregular portion and causes degradation of joint strength. Particularly, in order to volatilize the organic solvent in a region between the ceramic and the metal, the following means can be considered: a reduction in the pressure of a peripheral atmosphere, an increase in a heating temperature, and an increase in the time for the heat treatment. It is, however, difficult to remove the organic solvent from a central portion of a substrate. It is, therefore, difficult to obtain joint strength that is equal to or nearly equal to joint strength obtained when conventional blazing filler metal, solder, or the like is used.

Further, Patent Document 4 describes that it is preferable that a ceramic board have a small thickness (of preferably 0.2 to 0.6 mm) and a metal plate bonded to both surfaces of the ceramic board have a large thickness (of preferably 2 to 4 mm) in order to prevent the ceramic circuit board from being cracked and warped due to a change in an ambient temperature. However, ceramic with a larger thickness, a wiring metal plate with a smaller thickness, or a holding member with a larger thickness is required depending on a required insulation property (high surge voltage resistance) and required strength of the board.

An object of the invention is to provide a circuit board that is provided for a semiconductor module, simplifies constituent members, reduces warpage, caused by temperature cycles under a high temperature condition, of the circuit board, and has an excellent bonding reliability of a bonding portion and an excellent heat dissipation property.

### Means for Solving the Problems

According to the invention, a circuit board includes a holding member, a bonding layer, an insulating substrate, a bonding layer, and a circuit wiring board, which are sequentially stacked in this order. In the circuit board, the bonding layers are sintered bodies containing metal, the insulating substrate is made of non-oxide ceramic, and oxide layers are formed on both surfaces of the insulating substrate.

In addition, it is preferable that the bonding layers be made of silver or a composite material containing silver, and a bonding temperature be in a range of 180°C to 400°C.

Further, it is preferable that the thicknesses of the bonding layers be in a range of 10 µm to 200 µm.

In addition, it is preferable that the oxide layers have a thickness of 0.1 nm to 300 nm and be formed in 50% or more of regions in which the bonding layers are formed.

Further, it is preferable that the insulating substrate have a thermal expansion coefficient of 10 × 10⁻⁶/°C or lower at a temperature of -50°C to 200°C and deflective strength of 300 MPa or higher.

In addition, it is preferable that the insulating substrate be made of a nitride.

Further, it is preferable that the insulating substrate be made of a nitride containing silicon.

In addition, it is preferable that the holding member have a thermal expansion coefficient of 10 × 10⁻⁶/°C to 20 × 10⁻⁶/°C at a temperature of -50°C to 200°C, the thickness of the holding member be in a range of 0.5 mm to 20 mm in the regions in which the bonding layers are formed, and the thickness of the circuit wiring board be in a range of 0.5 mm to 3 mm.

Further, it is preferable that the holding member be made of copper or an alloy containing copper.

In addition, it is preferable that the holding member and the circuit wiring board have a thermal expansion coefficient of 20 × 10⁻⁶/°C to 30 × 10⁻⁶/°C at a temperature of -50°C to 200°C, the thickness of the holding member be in a range of 0.5 mm to 2 mm in the regions in which the bonding layers are formed, and the thickness of the circuit wiring board be larger than the holding member and 3 mm or less.

Further, it is preferable that the holding member and the circuit wiring board be made of aluminum or an alloy containing aluminum.

In addition, it is preferable that the region in which the bonding layer is formed between a metal plate for heat dissipation and the insulating substrate is narrower than an end portion of the metal plate for heat dissipation and wider than a region that is narrower by 1 mm than an outermost end of the bonding layer formed between the circuit wiring board and the insulating substrate.

Further, it is preferable that an area in which the circuit wiring board is formed be in a range of 70% to 95% of the area of the insulating substrate.

In addition, it is preferable that a plated layer made of a different material from the holding member or the circuit wiring board be formed on a part of the holding member or a part of the circuit wiring board.

Further, it is preferable that the area of a surface, contacting the bonding layer, of the circuit wiring board be smaller than the area of an opposing surface of the circuit wiring board.

### Effects of the Invention

According to the invention, a circuit board that is provided for a semiconductor module, simplifies constituent members, reduces warpage, caused by temperature cycles under a high temperature condition, of the circuit board, and has an excellent bonding reliability of a bonding portion and an excellent heat dissipation property can be provided.

### Brief Description of the Drawings

Fig. 1 illustrates the configuration of a circuit board according to the first to seventh embodiments.
Fig. 2 illustrates the states of interfaces between an insulating substrate and bonding layers according to the first to eleventh embodiments.
Fig. 3 illustrates the configuration of a circuit board according to the eighth and ninth embodiments.
Fig. 4 illustrates the configuration of a circuit board according to the tenth embodiment.
Fig. 5 illustrates the configuration of a board for a semiconductor module according to the eleventh embodiment.
Fig. 6 illustrates the configuration of a conventional circuit board.

### Mode for Carrying Out the Invention

Next, preferred embodiments of the invention are described.

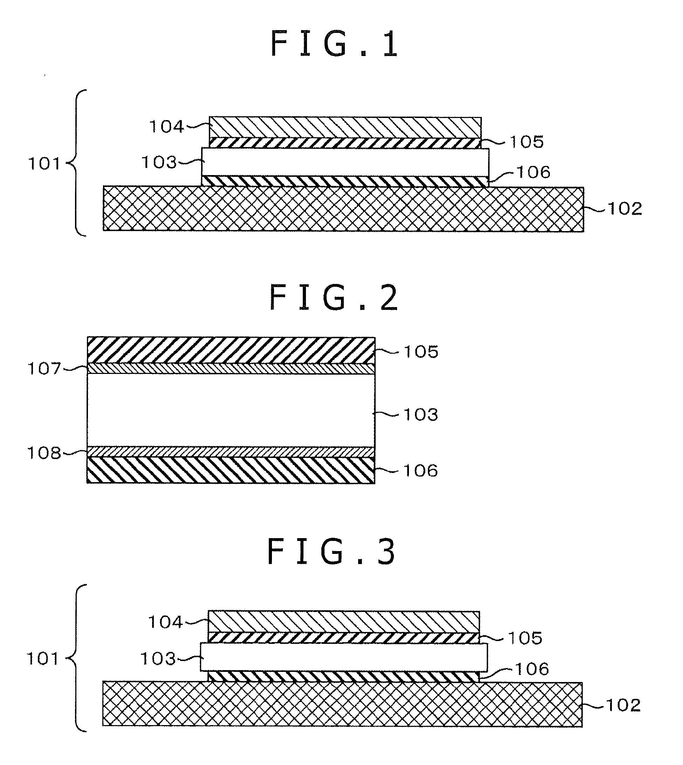

Fig. 1 is a diagram illustrating the configuration of a circuit board according to the present embodiment. The circuit board 101 has a holding member 102, a bonding layer 106, an insulating substrate 103, a bonding layer 105, and a circuit wiring board 104, which are sequentially stacked in this order. The bonding layers 105 and 106 are sintered bodies containing metal, while oxide layers are formed on both surfaces of the insulating substrate 103.

Metal with excellent thermal resistance and excellent thermal conductivity or a composite material containing the metal is suitable for the holding member 102. Specifically, copper, an alloy containing copper, aluminum, or an alloy containing aluminum is preferable.

In addition, a corrugated fin may be arranged on a surface opposing a surface contacting the bonding layer 106 and the holding member 102 so as to improve a heat dissipation property.

Ceramic that has excellent thermal resistance, pressure resistance, and high strength is suitable for the insulating substrate 103. Examples of the ceramic material include oxide containing aluminum or silicon or nitride containing aluminum or silicon. In particular, nitride that has high strength and excellent thermal conductivity is preferable. Specifically, the nitride includes aluminum nitride and silicon nitride. Particularly, a silicon nitride is known as high-strength ceramic. The thickness of the insulating substrate is determined on the basis of a dielectric strength voltage and strength that are required for the circuit board 101.

Metal with excellent thermal resistance, thermal conductivity, and electric conductivity or a composite material containing the metal is suitable for the circuit wiring board 104. Specifically, copper, an alloy containing copper, aluminum, or an alloy containing aluminum is preferable.

The sintered metal bodies are used for the bonding layers 105 and 106. It is preferable that the bonding layers 105 and 106 enable interfaces of the holding member 102 and insulating substrate 103 to be bonded and interfaces of the insulating substrate 103 and circuit wiring board 104 to be bonded at a low temperature. This is due to the fact that thermal stress remaining in the circuit board 101 after the bonding and the amount of warpage of the circuit board 101 after the bonding can be reduced by the bonding at the low temperature. According to the invention, a bonding technique using a bonding material composed of metal oxide particles and a reductant made of an organic material for reducing the metal oxide particles is used. The bonding technique uses an effect in which metal particles with the average diameter of 100 nm or less are generated by reducing the metal oxide particles upon heating and pressurization for the bonding and are sintered so as to change to bulk metal. The metal oxide particles are reduced by the reductant at a low temperature of 400°C or lower, and whereby metal particles with the average diameter of 100 nm or less are generated. Thus, the bonding at a low temperature of 400°C or lower can be performed according to the bonding technique. In addition, the bonding technique has a feature in which a temperature is instantaneously increased by reaction heat generated upon the reduction of the metal oxide particles, and the strong bonding with the bonding members is performed by the reaction heat. For example, when a bonding material that is obtained by dispersing primary alcohol such as cetyl alcohol composed of a silver oxide and a reductant in a solvent such as toluene and pasting the primary alcohol is used, and heating is performed at a temperature of 300°C under pressure of 0.5 MPa for five minutes, a sintered layer that is bonded to nitride ceramic is formed.

The metallic holding member 102 and the metallic circuit wiring board 104 cause metallic bonding with the bonding layer 105 and are therefore bonded to the bonding layer 105 with high strength. For the bonding with the insulating substrate 103 made of non-oxide ceramic, it is necessary to disperse a metal element in the ceramic using reaction heat generated by the reduction of the metal oxide particles and increase bonding strength. It is, however, not easy to disperse the metal element in the nitride. Thus, oxide layers in which the metal element easily disperses are formed on the surfaces of the nitride ceramic, and the dispersion of the metal particles is promoted. For example, oxide layers with a thickness of several nanometers can be formed on the ceramic surfaces by burning the ceramic substrate at a temperature of 1000°C in the atmosphere.

Examples of the metal oxide particles used for the bonding material include silver oxides (Ag₂O, AgO) and a copper oxide (CuO), and at least one type of metal among the groups can be used. Since only oxygen is generated from metal oxide particles of a silver oxide (Ag₂O, AgO) or a copper oxide (CuO) upon a reduction of the metal oxide particles, the metal oxide particles hardly remain after the bonding, and the rate of decreasing the volume is low. In addition, the average diameter of the metal oxide particles is preferably 1 nm or more and 100 µm or less, more preferably 50 µm or less. The reason that the preferable average diameter is 100 µm or less is that a metal particle with a diameter of 100 nm or less is hardly generated due to the reduction of the metal oxide particles upon the bonding, the number of gaps between particles increases, and it is difficult to form a precise bonding layer. In addition, the reason that the preferable average diameter is 1 nm or more is that it is difficult to generate metal oxide particles with the average diameter of 1 nm or less. In addition, since the bonding is performed by generating metal particles with diameters of 100 nm or less in the bonding material during the bonding, it is not necessary that the diameters of the metal oxide particles be 100 nm or less. From the perspective of generation, handling and long-term preservation of the metal oxide particles, it is preferable that particles with the average diameter of 1 µm or more be used.

It is sufficient if the reductant that is used for the bonding material has an effect of reducing the metal oxide particles. For example, an organic material of one or more types selected from alcohol, carboxylic acids, and amine can be used.

An example of an available compound that contains an alcohol group is alkyl alcohol. For example, ethanol, propanol, butyl alcohol, pentyl alcohol, hexyl alcohol, heptyl alcohol, octyl alcohol, nonyl alcohol, decyl alcohol, undecyl alcohol, dodecyl alcohol, tridecyl alcohol, tetradecyl alcohol, pentadecyl alcohol, hexadecyl alcohol, heptadecyl alcohol, octadecyl alcohol, nonadecyl alcohol, and icosyl alcohol can be used as the compound containing the alcohol group. In addition, a secondary alcohol type, a tertiary alcohol type, alkane diol, and an alcohol compound having an annular structure can be used as well as the primary alcohol. Furthermore, compounds containing many alcohol groups such as ethylene glycol and triethylene glycol may be used. In addition, compounds such as a citric acid, an ascorbic acid, and glucose may be used.

An available compound that contains a carboxylic acid is an alkylcarboxylic acid. Specific examples of the compound include a butanoic acid, a pentanoic acid, a hexanoic acid, a heptanoic acid, an octanoic acid, a nonanoic acid, a decanoic acid, an undecanoic acid, a dodecanoic acid, a tridecanoic acid, a tetradecanoic acid, a pentadecanoic acid, a hexadecanoic acid, a heptadecanoic acid, an octadecanoic acid, a nonadecanoic acid, and an icosanoic acid. Similarly to the amino group, a secondary carboxylic acid type, a tertiary carboxylic acid type, a dicarboxylic acid, and a carboxyl compound having an annular structure can be used as well as the primary carboxylic acid type.

In addition, an example of an available compound that contains an amino group is alkylamine. Examples of the compound include butylamine, pentylamine, hexylamine, heptylamine, octylamine, nonylamine, decylamine, undecylamine, dodecylamine, tridecylamine, tetradecylamine, pentadecylamine, hexadecylamine, heptadecylamine, octadecylamine, nonadecylamine, and icodecylamine. In addition, the compound containing the amino group may have a branched structure. Examples of the compound include 2-ethylhexylamine and 1,5-dimethyl-hexylamine. In addition, a secondary amine type and a tertiary amine type can be used as well as the primary amine type. Furthermore, the aforementioned organic materials may have an annular shape.

The reductant is not limited to the organic materials containing the alcohol, the organic materials containing the carboxylic acids, and the organic materials containing the amine. As the reductant, an organic material containing an aldehyde group, an ester group, a ketone group, or the like, or a compound containing an organic material such as carboxylic acid metal salt may be used. Although the carboxylic acid metal salt is also used as precursors of the metal particles, it contains an organic material and may be used as the reductant for the metal oxide particles. A reductant that has a lower melting point than the bonding temperature is aggregated upon the bonding and causes a void. Since the carboxylic acid metal salt or the like is not melted by heat upon the bonding, however, it can be used to reduce a void, for example. A metal compound containing an organic material may be used as the reductant as well as the carboxylic acid metal salt.

If a reductant that is ethylene glycol, triethylene glycol, or the like and is a liquid at a temperature of 20°C to 30°C is mixed with a silver oxide (Ag₂O) or the like and left, the reductant is reduced to silver one day after the mixing and thus required to be used immediately after the mixing. Even if myristyl alcohol, laurylamine, an ascorbic acid and the like are left with a metal oxide or the like for a month or so, a reaction does not significantly progress. Thus, they have an excellent preserving property and are preferably used in the case of being stored for a long time. Since the reductant to be used acts as a protective film for refined metal particles with diameters of 100 nm or less after the reduction of the metal oxide or the like, a carbon number is preferably a certain number. Specifically, it is desirable that the carbon number be 2 or more and 20 or less. If the carbon number is smaller than 2, particle diameter growth occurs simultaneously with the generation of the metal particles and it is difficult to generate metal particles with diameters of 100 nm or less. If the carbon number is larger than 20, a decomposition temperature is higher and sintering of the metal particles hardly occurs. As a result, the bonding strength is reduced.

It is sufficient if the amount of the reductant to be used is in a range of 1 part by weight to 50 parts by weight of the total weight of the precursors of the metal particles. If the amount of the reductant is smaller than 1 part by weight, the amount of the reductant is not sufficient to reduce all the precursors of the metal particles of the bonding material and generate the metal particles. If the amount of the reductant is larger than 50 part by weight, the amount of a residue after the bonding is large and it is difficult to achieve the metallic bonding at the interfaces and densification in the bonding silver layers. If the reductant is composed of only an organic material, it is preferable that the rate of reducing a thermal weight loss rate upon heating at a temperature of up to 400°C be 99% or higher. This is due to the fact that if the decomposition temperature of the reductant is high, the amount of the residue after the bonding is large, and it is difficult to achieve the metallic bonding at the interfaces and the densification in the bonding silver layers. It is assumed that the measurement of the thermal weight loss rate upon the heating at the temperature of up to 400°C is performed at 10°C/min in the atmosphere using a device capable of measuring a thermal weight, while the device is TG/DTA6200 made by Seiko Instruments, TGA-50 made by Shimadzu Corporation, or the like.

A combination of the precursors of the metal particles and the reductant composed of an organic material is not limited as long as the metal particles can be generated by mixing them. From the perspective of a preserving property of the bonding material, it is preferable that the combination do not cause a metal particle to be generated at a room temperature.

In addition, metal particles with a relatively large average diameter of 50 µm to 100 µm can be mixed in the bonding material and used. This is due to the fact that the metal particles that are generated during the bonding and have the average diameter of 100 nm or less have a role to cause the metal particles with the average diameter of 50 µm to 100 µm to be sintered with each other. In addition, the metal particles with the diameters of 100 nm or less may be mixed in advance. Examples of the type of the metal particles include gold, silver, and copper. One type of metal or an alloy of two or more types of metal among platinum, palladium, rhodium, osmium, ruthenium, iridium, iron, tin, zinc, cobalt, nickel, chrome, titanium, tantalum, tungsten, indium, silicon, aluminum, and the like can be used as well as the aforementioned metal.

Although a reductant that contains the precursors of the metal particles and an organic material may be used as the bonding material used in the present embodiment, a solvent may be added to the reductant when the reductant is used as a paste-like reductant. If the reductant is used immediately after the mixing, a material that has a reduction effect and is alcohol such as methanol, ethanol, propanol, ethylene glycol, triethylene glycol, or terpineol, or the like may be used. However, if the reductant is stored for a long time, it is preferable that a material that has a weak reduction effect at a room temperature, such as water, hexane, tetrahydrofuran, toluene, or cyclohexane be used. In addition, if a material that hardly causes a reduction at a room temperature, such as myristyl alcohol is used as the reductant, the reductant can be stored for a long time. If a material that has a strong reduction effect, such as ethylene glycol is used as the reductant, it is preferable that the mixing be performed for use of the reductant.

To improve dispersibility of the precursors of the metal particles in the solvent, a dispersant may be used as required so as to cause an organic material to cover the precursors of the metal particles. Examples of the dispersant used for the present invention include polyvinyl alcohol, polyacrylonitrile, polyvinylpyrrolidone, and polyethyleneglycol. In addition, as a commercial dispersant, the following polymer dispersants can be used: DISPERBYK®-160, DISPERBYK®-161, DISPERBYK®-162, DISPERBYK®-163, DISPERBYK®-166, DISPERBYK®-170, DISPERBYK®-180, DISPERBYK®-182, DISPERBYK®-184, DISPERBYK®-190 (that are made by BYK Chemie), MEGAFAC F-479 (made by Dainippon Ink), Solsperse®20000, Solsperse®24000, Solsperse®26000, Solsperse®27000, and Solsperse®28000 (made by Avecia). The amount of the dispersant to be used for the precursors of the metal particles is equal to or larger than 0.01 wt% and smaller than 45 wt% in the bonding material. Warpage, caused by the bonding process, of the circuit board 101 can be suppressed by simultaneously bonding the holding member 102, the insulating substrate 103, and the circuit wiring board 104 for formation of the circuit board 101. Fig. 2 is a schematic diagram illustrating the states of interfaces between the insulating substrate 103 and the bonding layers 105 and 106 in the circuit board 101 illustrated in Fig. 1. A pasted silver oxide bonding material is coated on both surfaces of the insulating substrate 103 having oxide layers 107 and 108 formed on its surfaces. Then, the holding member 102 is formed under one of the surfaces of the insulating substrate 103, while the circuit wiring board 104 is formed above the other surface of the insulating substrate 103. The circuit board 101 that is unified by the bonding layers 105 and 106 made of silver sintered bodies can be obtained by heating at a temperature of 300°C under pressure of 0.5 MPa for five minutes.

Thermal expansion coefficients of the circuit wiring board 104 and holding member 102 that are made of metal are different from a thermal expansion coefficient of the insulating substrate 103 made of ceramic. Specifically, thermal expansion coefficients of copper and aluminum are in a range of 15 × 10⁻⁶ /°C to 25 × 10⁻⁶ /°C, whereas a thermal expansion coefficient of a general nitride ceramic material is in a range of 2 × 10⁻⁶ /°C to 6 × 10⁻⁶ /°C. In regions in which the members are bonded, the circuit board 101 is affected by the difference between the thermal expansion coefficients and expanded or contracted toward the holding member 102 or the circuit wiring board 104 with respect to the insulating substrate 103 in the bonding process or due to a change in the temperature upon use of the board. In order to suppress the amount of the warpage, the ratio of the thicknesses of the holding member 102 and circuit wiring board 104 and the difference between the thermal expansion coefficients are set by changing the materials so that the expansion and contraction of the circuit board 101 are symmetric about the insulating substrate 103. For example, if a flat plate with a thickness of 1 mm is used as the holding member 102, a ceramic plate with a thickness of 0.64 mm is used as the insulating substrate 103, a flat plate that is made of a material with the same thermal expansion coefficient as the holding member 102 is used as the circuit wiring board 104, the thickness of the circuit wiring board 104 is set to 1.3 mm. Even if the temperature changes by 200°C in this case, the amount of warpage of the circuit board 101 can be suppressed to 0.1 mm or less. In addition, since copper and aluminum that have excellent thermal conductivity can be used and the number of bonding layers can be reduced, thermal resistance of the overall circuit board is reduced.

As a result, even if an ambient temperature of a semiconductor device increases due to an external cause or heat generated by a semiconductor substrate is high, the amount of warpage of the circuit board can be reduced, and the semiconductor module circuit board can be provided that efficiently dissipates heat generated by the semiconductor substrate, has high reliability, and can be easily formed.

In the present embodiment, the thickness of the holding member 102 is not limited, but is preferably in a range of 0.5 mm to 20 mm from the perspective of a reduction in the weight of the circuit board and an increase in the strength of the circuit board.

In addition, the thickness of the insulating substrate 103 is not limited, but is preferably in a range of 0.1 mm to 1 mm from the perspective of a dielectric strength voltage and strength that are required for the circuit board. The larger the thickness, the higher the dielectric strength voltage and the strength.

In addition, the thickness of the circuit wiring board 104 is not limited, but is preferably 3 mm or less from the perspective of the easiness of processing of a wiring pattern.

In addition, the thicknesses of the bonding layers 105 and 106 are not limited, but are preferably in a range of 10 µm to 200 µm in consideration of the amount of the bonding material to be supplied and the simplification of the bonding process.

It is necessary that the bonding temperature be lower than the melting points of other members used for the circuit board and high enough to cause the organic solvent to volatilize. In addition, it is desirable that the bonding temperature be low in order to reduce warpage and stress of the circuit board after the bonding. Specifically, if the bonding temperature is in a range of 180°C to 400°C, the circuit board can be configured and highly reliable. It is, therefore, preferable that the metal oxide particles and the reductant that cause a reduction reaction of the metal oxide particles at a temperature of 400°C or lower be combined and used.

In the present embodiment, the pasted bonding material that contains metal oxide particles is coated between the members, heated and pressurized and then forms the bonding layers. If the bonding material can be appropriately supplied to the bonding portions, however, it is not necessary that the bonding material be pasted. For example, a sheet material that has a core material with surfaces on which silver oxide layers are formed may be used. The sheet material is formed by forming the silver oxide layers on both surfaces of the core material made of any of, or an alloy of silver, gold, copper, platinum, nickel, cobalt, silicon, aluminum, and the like. The bonding can be achieved by supplying the reductant to the silver oxide layers of the sheet material and heating. The thicknesses of the bonding layers and the bonding regions can be easily controlled by using the sheet material.

In the present embodiment, the oxide layers are formed on both surfaces of the insulating substrate, but need to be formed in wide ranges of the bonding surfaces for high-strength bonding. It is desirable that the ranges in which the oxide layers are formed be equal to or larger than 50% of regions in which the bonding layers are formed. In addition, as the thicknesses of the oxide layers are increased, the strength and the thermal conductivity are reduced. It is, therefore, desirable that the thicknesses of the oxide layers be in a range of 0.1 nm to 200 nm.

In the present embodiment, the burning is performed in the atmosphere in order to form the oxide layers on both surfaces of the insulating substrate, but may be performed in a highly-concentrated oxygen atmosphere. In addition, as means for stacking the oxide layers on the surfaces of the insulating substrate, a film formation technique such as an evaporation method, a spraying method, or an aerosol deposition method may be used.

In the present embodiment, in order to suppress the amount of warpage of the circuit board, the ratio of the thicknesses of the holding member and circuit wiring board and the difference (caused by changing the materials) between the thermal expansion coefficients are set so that the expansion and contraction of the circuit board are symmetric about the insulating substrate. If the holding member is made of copper or an alloy containing copper, the ratio of the thicknesses is optimized by setting the thickness of the holding member to a range of 0.5 mm to 20 mm and the thickness of the circuit wiring board to a range of 0.5 mm to 3 mm in the regions in which the bonding layers are formed, and whereby the amount of warpage of the circuit board can be suppressed. In addition, if the holding member and the circuit wiring board are made of aluminum or an alloy of aluminum, the ratio of the thicknesses is optimized by setting the thickness of the holding member to a range of 0.5 mm to 2 mm and the thickness of the circuit wiring board to a value that is lager than the thickness of the holding member and equal to or smaller than 3 mm in the regions in which the bonding layers are formed, and whereby the amount of warpage of the circuit board can be suppressed.

In the present embodiment, the warpage of the circuit board and stress to be applied to the insulating substrate can be reduced by setting the size of the region in which the bonding layer is formed between a metal plate for heat dissipation and the insulating substrate, to a size that is narrower than an end portion of the metal plate for heat dissipation and wider than a size that is smaller by 1 mm than an outermost end of the bonding layer formed between the circuit wiring board and the insulating substrate. Particularly, it is efficient to suppress the size of the region in which the bonding layer is formed to a size that is equal to or different by a range of -0.5 mm to +0.5 mm from the outermost end of the bonding layer formed between the circuit wiring board and the insulating substrate.

Although the present embodiment does not describe that the sizes of bonding surfaces of the holding member, insulating substrate, circuit wiring board, and bonding layers, a power module can be easily installed in a power conversion system by setting the area of the holding member to a larger value than that of the insulating substrate and setting the area of the circuit wiring board to a smaller value than that of the insulating substrate, depending on a method for using the power module in which the semiconductor substrate is mounted on the circuit board. A method for using the power module, however, does not depend on the area ratios.

Although the present embodiment does not describe a wiring pattern of the circuit wiring board and a formation density, it is desirable that the density at which the wiring pattern is formed be high in consideration of a density of the circuit members in the semiconductor module. In addition, from the perspective of an insulation property, it is desirable that an outermost end of the circuit wiring board be narrower than the insulating substrate. It is, therefore, desirable that an area in which the circuit wiring board is formed be in a range of 70% to 95% of the area of the insulating substrate. As a method for processing the wiring pattern, etching, cutting, a punching method and the like may be used on the basis of the thickness.

Although the present embodiment does not describe the states of surfaces of the holding member and circuit wiring board, a metal layer that is made of a different material from the holding member or the circuit wiring board may be formed on at least a part of the holding member or at least a part of the circuit wiring board in consideration of a property of bonding to the bonding material. For example, a plated layer of nickel, silver, or the like may be formed and have a thickness of 1 µm to 10 µm. In addition, a region in which the plated layer is formed is not limited to the overall surface of the holding member or circuit wiring board. For example, it is sufficient if the plated layer is formed only near the regions in which the bonding layers are formed, the regions in which the semiconductor substrate is bonded, or a region in which a wire and a ribbon wire are bonded, or regions in which electrode terminals are bonded.

Although the present embodiment does not describe an area ratio of the surface, contacting the bonding layer, of the circuit wiring board and the surface, opposing the bonding layer, of the circuit wiring board, the area of the surface contacting the bonding layer may be different from the area of the opposing surface of the circuit wiring board. For example, side surfaces may be inclined so that the area varies in the thickness direction. By setting the area of the surface contacting the bonding layer to a smaller value than the area of the opposing surface, distances from end portions of the insulating substrate can be increased and the insulation property can be improved without a reduction in the area in which the semiconductor substrate is formed. In addition, sealing resin is poured into a space formed between the circuit wiring board and the insulating substrate in order to seal the circuit board using the resin after the semiconductor substrate is formed, and whereby the anchor effect of the resin and the metal can be improved.

The circuit board according to the present invention can be used as a circuit board for mounting and driving a semiconductor element for an electric power converter and an optical semiconductor element that is an LED or the like and generates heat, while the semiconductor elements are used for power conversion systems for vehicles, wind power generation, railways, and industrial equipment.

### First Embodiment

### (Cu base 1 mm/Cu wiring)

In the present embodiment, the configuration of the circuit board illustrated in Fig. 1 and a method for forming the circuit board illustrated in Fig. 1 are described.

As illustrated in Fig. 1, the circuit board 101 is configured by sequentially stacking the flat holding member 102, the bonding layer 106, the flat insulating substrate 103, the bonding layer 105, and the flat circuit wiring board 104 in this order.

As the holding member 102, a copper plate that has a size of 82 mm × 92 mm and a thickness of 1 mm was used. The copper plate was formed by processing oxygen-free copper with a purity of 99.95%.

As the insulating substrate 103, a silicon nitride substrate that has a size of 49 mm × 55 mm and a thickness of 0.64 mm was used. As the silicon nitride substrate, a commercial product that has a dielectric strength voltage of 6 kV or higher and deflective strength of 750 MPa or higher was selected.

As the circuit wiring boards 104, copper plates each having outermost ends of 46 mm × 52 mm were used. The circuit wiring boards 104 each have a wiring pattern occupying 77% of the area of the surface of the insulating substrate 103. The copper plates that are of three types and each have different thicknesses were prepared. The thicknesses of the copper plates were 1 mm, 1.3 mm, and 2 mm. The circuit wiring boards were formed by processing oxygen-free copper with a purity of 99.99%.

In order to bond the insulating substrate 103 to the bonding layers 105 and 106 with high strength, the insulating substrate 103 was burned in the atmosphere at a temperature of 1000°C for 30 minutes, and the oxide layers were formed on the overall surfaces of the insulating substrate. It was confirmed that an amorphous oxide layer was formed from the top surface to a depth of 0.5 nm, when a cross section of the insulating substrate 103 was observed using an electronic microscope after the burning.

As the bonding material forming the bonding layers 105 and 106, a paste material that is obtained by dispersing silver oxide particles with the average diameter of 100 µm or less and a reductant of cetyl alcohol into toluene was prepared.

The paste material with an appropriate amount was coated on the surface, facing the holding member 102, of the insulating substrate 103 having the oxide layers thereon and on the surface, facing the insulating substrate 103, of the circuit wiring board 104. The holding member 102, the insulating substrate 103, and the circuit wiring board 104 were sequentially stacked in this order. Then, the circuit boards 101 each having the bonding layers 105 and 106 made of silver sintered bodies with the average thickness of 0.05 nm were obtained by heating at a temperature of 300°C in the atmosphere under pressure of 0.5 MPa for five minutes. It is noted that the obtained circuit boards 101 were of three types, and the thicknesses of the circuit wiring boards of the circuit boards were different from each other.

The amounts of warpage of the holding members 102 were measured using the circuit boards 101 after the bonding. Results are shown in Table 1. When the thicknesses of the circuit wiring boards 104 were 1 mm and 1.3 mm, the holding members 102 were warped and convex toward the side of the circuit wiring boards 104 (the amount of the warpage is represented by +). When the thickness of the circuit wiring board 104 was 2 mm, the holding member 102 was warped and convex toward the opposite side to the circuit wiring board 104 (the amount of the warpage is represented by -). The amounts of the warpage, which are shown in Table 1, are measured in central portions (maximum values of the convex amounts) of the holding members 102. Thus, when the thickness of the circuit wiring board 104 was 1.3 mm and larger than the thickness of the holding member 102, the amount of the warpage of the holding member 102 after the bonding was most suppressed.

**[Table 1]**

| | | | |
|---|---|---|---|
| The thickness of the circuit wiring board (mm) | 1.0 | 1.3 | 2.0 |
| Warpage of the holding member after the bonding (mm) | 0.45 | 0.05 | -0.3 |
| Warpage of the holding member upon a change in an ambient temperature (mm) | 0.15 | 0.03 | -0.1 |

Results of measuring the amounts of warpage of the holding members 102 upon a change in the ambient temperature by heating the circuit boards 101 at a temperature of 200°C are also shown in Table 1. When the thickness of the circuit wiring board 104 is 1.3 mm which is larger than the holding member 102, the changed amount of warpage of the holding member 102 is smallest, like the amount of the warpage after the bonding.

When the circuit boards 101 were subjected to a temperature cycle experiment (-45°C to 200°C, 1000 cycles, the 30 boards (10 samples × 3 types) subjected to the temperature cycle experiment), peeling of the bonding portions of all the samples and damage of the members were not observed.

### [Comparative Example] (AlSiC base)

As a comparative example, a conventional circuit board 301 illustrated in Fig. 6 was experimentally formed, and the amount of warpage of a holding member 302 was evaluated.

As illustrated in Fig. 6, the circuit board 301 was configured by sequentially stacking the holding member 302, a solder layer 308, a circuit wiring board 305, a bonding layer 306, an insulating substrate 303, a bonding layer 307, and a circuit wiring board 304 in this order.

As the holding member 302, aluminum-silicon carbide that has a size of 82 mm × 92 mm and a thickness of 5 mm was used.

As the insulating substrate 303, an aluminum nitride substrate that has a size of 49 mm × 55 mm and a thickness of 0.7 mm was used. For the aluminum nitride substrate, a commercial product that has a dielectric strength voltage of 6 kV or higher and deflective strength of 300 MPa or higher was selected.

As the circuit wiring boards 304 and 305, pure aluminum plates each having outermost ends of 46 mm × 52 mm were used. The circuit wiring board 304 has a wiring pattern occupying 77% of the area of a surface of the insulating substrate 303. The thickness of the circuit wiring board 304 was 0.4 mm, while the thickness of the circuit wiring board 305 was 0.3 mm.

As a bonding material forming the bonding layers 306 and 307 and the solder layer 308, commercial lead-free solder was used.

The conventional circuit board 301 was obtained by bonding an insulating circuit member composed of the insulating substrate 303 attached to the circuit wiring boards 304 and 305 to the holding member 302 through the solder layer 308.

In the obtained circuit board 301, the holding member 302 was warped and convex toward the opposite side to the circuit wiring board 304. The amount of the warpage of the holding member 302 was measured and 0.15 mm.

In addition, when the circuit board 301 was heated at a temperature of 200°C and the amount of warpage of the holding member 102 upon a change in an ambient temperature was measured, the holding member 302 was warped by 0.05 mm and convex toward the opposite side to the circuit wiring board 304. Specifically, the amount of the warpage changed by approximately 0.1 mm.

When the circuit boards 301 were subjected to the temperature cycle experiment (-45°C to 200°C, 1000 cycles, the 30 boards (10 samples × 3 types) subjected to the temperature cycle experiment), peeling of bonding portions of all the samples and damage of the members were not observed.

Based on the aforementioned results, it can be said that if the amount of warpage of the holding member 302 after bonding is 0.15 mm or less and the amount of warpage of the holding member 302 upon a change in the ambient temperature of the conventional circuit board 301 is 0.1 mm or less, there is no problem for use.

Thus, if the thickness of the circuit wiring board 104 of the circuit board 101 according to the first embodiment is 1.3 mm, the amounts of the warpage after the bonding and upon an increase, caused by an external cause, in the ambient temperature are suppressed compared with the conventional circuit board 301, and it can be said that the circuit board 101 can be used as a circuit board for a semiconductor module. In addition, since the circuit board 101 according to the first embodiment is thinner than the conventional circuit board 301, thermal resistance of the circuit board is reduced. Furthermore, the number of the members is 3 and the number of the bonding layers is 2 in the circuit board 101 according to the first embodiment, while the number of the members is 4 and the number of the bonding layers is 3 in the conventional circuit board 301. Thus, the formation process can be simplified.

### Second Embodiment

### (Cu base 10 mm/Cu wiring)

The present embodiment describes configurations of the circuit board, which are different from the first embodiment.

The configuration of the circuit board illustrated in Fig. 1 and the process of forming the circuit board illustrated in Fig. 1 are already described, and a description thereof is omitted.

As the holding member 102, a copper plate that has a size of 82 mm × 92 mm and a thickness of 10 mm was used.

As the circuit wiring boards 104, copper plates each having outermost ends of 46 mm × 52 mm were used. The copper plates that are of three types and each have different thicknesses of 1 mm, 2 mm, and 3 mm were prepared.

The insulating substrate and the bonding layers are the same as the first embodiment, and a description thereof is omitted.

The circuit boards 101 were obtained by being pressurized in the atmosphere at a temperature of 250°C under pressure of 2.5 MPa for 2 minutes according to the same procedure as the first embodiment.

The amounts of warpage of the holding members 102 were measured using the obtained circuit boards 101. Results are shown in Table 2. When the thicknesses of the circuit wiring boards 104 were in a range of 1 mm to 3 mm, the holding members 102 were warped and convex toward the side of the circuit wiring boards 104. When the thicknesses of the circuit wiring boards 104 were 2 mm and 3 mm, the amounts of warpage of the holding members 102 after the bonding were 0.15 mm or less.

**[Table 2]**

| | | | |
|---|---|---|---|
| The thickness of the circuit wiring board (mm) | 1 | 2 | 3 |
| Warpage of the holding member after the bonding (mm) | 0.20 | 0.15 | 0.10 |
| Warpage of the holding member upon a change in the ambient temperature (mm) | 0.01 | 0.01 | 0.01 |

Results of measuring the amounts of warpage of the holding members 102 upon a change in the ambient temperature by heating the circuit boards 101 at a temperature of 200°C are also shown in Table 2. When the thickness of the circuit wiring board 104 was 3 mm, the changed amount of warpage of the holding member 102 was 0.1 mm, like the amount of the warpage after the bonding.

When the circuit boards 101 were subjected to the temperature cycle experiment (-45°C to 200°C, 1000 cycles, the 30 boards (10 samples × 3 types) subjected to the temperature cycle experiment), peeling of the bonding portions of all the samples and damage of the members were not observed.

### Third Embodiment

### (Cu base 10 mm/Al wiring)

The present embodiment describes configurations of the circuit board, which are different from the first embodiment.

The configuration of the circuit board illustrated in Fig. 1 and the process of forming the circuit board illustrated in Fig. 1 are already described, and a description thereof is omitted.

As the holding member 102, a copper plate that has a size of 82 mm × 92 mm and a thickness of 10 mm was used.

As the circuit wiring boards 104, aluminum plates each having outermost ends of 46 mm × 52 mm were used. The copper plates that are of three types and each have different thicknesses of 1 mm, 2 mm, and 3 mm were prepared. The aluminum plates were formed by processing pure aluminum with a purity of 99%.

The insulating substrate and the bonding layers are the same as the first embodiment, and a description thereof is omitted.

The amounts of warpage of the holding members 102 were measured using the circuit boards 101 obtained through the same formation process as the first embodiment. Results are shown in Table 3. When the thicknesses of the circuit wiring boards 104 were in a range of 1 mm to 3 mm, the holding members 102 were warped and convex toward the side of the circuit wiring boards 104. When the thicknesses of the circuit wiring boards 104 were 2 mm and 3 mm, the amounts of warpage of the holding members 102 after the bonding were suppressed to 0.15 mm or less.

**[Table 3]**

| | | | |
|---|---|---|---|
| The thickness of the circuit wiring board (mm) | 1 | 2 | 3 |
| Warpage of the holding member after the bonding (mm) | 0.25 | 0.15 | 0.05 |
| Warpage of the holding member upon a change in the ambient temperature (mm) | 0.1 | 0.05 | 0.01 |

Results of measuring the amounts of warpage of the holding members 102 upon a change in the ambient temperature by heating the circuit boards 101 at a temperature of 200°C are also shown in Table 3. When the thicknesses of the circuit wiring boards 104 were 2 mm and 3 mm, the amounts of warpage of the holding members 102 were 0.1 mm or less, like the amount of the warpage after the bonding.

When the circuit boards 101 were subjected to the temperature cycle experiment (-45°C to 200°C, 1000 cycles, the 30 boards (10 samples × 3 types) subjected to the temperature cycle experiment), peeling of the bonding portions of all the samples and damage of the members were not observed.

As a result, when the thicknesses of the circuit wiring boards 104 were in a range of 2 mm to 3 mm, the amounts of the warpage were suppressed to values that were equal to or close to the conventional circuit board 301 (Fig. 6) or less.

### Fourth Embodiment

### (Cu base 5 mm/Al wiring)

The present embodiment describes configurations of the circuit board, which are different from the third embodiment.

The configuration of the circuit board illustrated in Fig. 1 and the process of forming the circuit board illustrated in Fig. 1 are already described, and a description thereof is omitted.

As the holding member 102, a copper plate that has a size of 82 mm × 92 mm and a thickness of 5 mm was used.

As the circuit wiring boards 104, aluminum plates each having outermost ends of 46 mm × 52 mm were used. The circuit wiring boards 104 each have a wiring pattern occupying 86% of the area of the surface of the insulating substrate 103. The copper plates that are of three types and each have different thicknesses of 2 mm, 2.5 mm, and 3 mm were prepared.

The insulating substrate and the bonding layers are the same as the third embodiment, and a description thereof is omitted.

The amounts of warpage of the holding members 102 were measured using the circuit boards 101 obtained through the same formation process as the third embodiment. Results are shown in Table 4. When the thicknesses of the circuit wiring boards 104 were 2.5 mm and 3 mm, the amounts of warpage of the holding members 102 after the bonding were suppressed to 0.15 mm or less.

**[Table 4]**

| | | | |
|---|---|---|---|
| The thickness of the circuit wiring board (mm) | 2 | 2.5 | 3 |
| Warpage of the holding member after the bonding (mm) | 0.2 | 0.1 | -0.05 |
| Warpage of the holding member upon a change in the ambient temperature (mm) | 0.05 | 0.02 | -0.02 |

Results of measuring the amounts of warpage of the holding members 102 upon a change in the ambient temperature by heating the circuit boards 101 at a temperature of 200°C are also shown in Table 4. When the thicknesses of the circuit wiring boards 104 were 2.5 mm and 3 mm, the amounts of warpage of the holding members 102 were 0.1 mm or less.

When the circuit boards 101 were subjected to the temperature cycle experiment (-45°C to 200°C, 1000 cycles, the 30 boards (10 samples × 3 types) subjected to the temperature cycle experiment), peeling of the bonding portions of all the samples and damage of the members were not observed.

As a result, when the thicknesses of the circuit wiring board 104 were in a range of 2.5 mm to 3 mm, the amounts of the warpage were suppressed to values that were equal to or close to the conventional circuit board 301 (Fig. 6) or less.

### Fifth Embodiment

### (Cu base 1 mm/Al wiring)

The present embodiment describes configurations of the circuit board, which are different from the fourth embodiment.

The configuration of the circuit board illustrated in Fig. 1 and the process of forming the circuit board illustrated in Fig. 1 are already described, and a description thereof is omitted.

As the holding member 102, a copper plate that has a size of 82 mm × 92 mm and a thickness of 1 mm was used.

As the circuit wiring boards 104, aluminum plates each having outermost ends of 46 mm × 52 mm were used. The circuit wiring boards 104 each have a wiring pattern occupying 86% of the area of the surface of the insulating substrate 103. The copper plates that are of three types and each have different thicknesses of 0.5 mm, 1 mm, and 2 mm were prepared.

The insulating substrate and the bonding layers are the same as the fourth embodiment, and a description thereof is omitted.

The amounts of warpage of the holding members 102 were measured using the circuit boards 101 obtained through the same formation process as the third embodiment. Results are shown in Table 5. When the thicknesses of the circuit wiring boards 104 were 1 mm and 3 mm, the amounts of the warpage of the holding members 102 after the bonding were suppressed to 0.15 mm or less.

**[Table 5]**

| | | | |
|---|---|---|---|
| The thickness of the circuit wiring board (mm) | 0.5 | 1 | 2 |
| Warpage of the holding member after the bonding (mm) | 1.8 | -0.05 | -1.1 |
| Warpage of the holding member upon a change in the ambient temperature (mm) | 0.4 | 0.01 | -0.2 |

Results of measuring the amounts of warpage of the holding numbers 102 upon a change in the ambient temperature by heating the circuit boards 101 at a temperature of 200°C are also shown in Table 5. When the thickness of the circuit wiring board 104 was 1 mm, the amount of the warpage of the holding member 102 was 0.1 mm or less.

When the circuit boards 101 were subjected to the temperature cycle experiment (-45°C to 200°C, 1000 cycles, the 30 boards (10 samples × 3 types) subjected to the temperature cycle experiment), peeling from an end portion of the bonding layer was observed between the circuit wiring board 104 and the bonding layer 105 from each of four circuit boards provided with the circuit wiring boards 104 that have a thickness of 2 mm. Peeling of the bonding portions of the other circuit boards and damage of the members were not observed from the other circuit boards.

As a result, when the thickness of the circuit wiring board 104 was approximately 1 mm, the amount of the warpage was suppressed to a value that was equal to or close to the conventional circuit board 301 (Fig. 6) or less.

### Sixth Embodiment

### (Al base 1 mm/Al wiring)

The present embodiment describes configurations of the circuit board, which are different from the first embodiment.

The configuration of the circuit board illustrated in Fig. 1 and the process of forming the circuit board illustrated in Fig. 1 are already described, and a description thereof is omitted.

As the holding member 102, an aluminum plate that has a size of 82 mm × 92 mm and a thickness of 1 mm was used.

As the circuit wiring boards 104, aluminum plates each having outermost ends of 46 mm × 52 mm were used. The circuit wiring boards 104 each have a wiring pattern occupying 86% of the area of the surface of the insulating substrate 103. The copper plates that are of three types and each have different thicknesses of 1.2 mm, 1.3 mm, and 1.4 mm were prepared.

The insulating substrate and the bonding layers are the same as the first embodiment, and a description thereof is omitted.

The amounts of warpage of the holding members 102 were measured using the circuit boards 101 obtained through the same formation process as the first embodiment. Results are shown in Table 6. When the thickness of the circuit wiring board 104 was 1.2 mm, the holding member 102 was warped and convex toward the side of the circuit wiring board 104. When the thicknesses of the circuit wiring boards 104 were 1.3 mm and 1.4 mm, the holding members 102 were warped and convex toward the opposite side to the circuit wiring boards 104. When the thickness of the circuit wiring board 104 was 1.3 mm, the amount of the warpage of the holding member 102 after the bonding was suppressed to 0.1 mm.

**[Table 6]**

| | | | |
|---|---|---|---|
| The thickness of the circuit wiring board (mm) | 1.2 | 1.3 | 1.4 |
| Warpage of the holding member after the bonding (mm) | 0.2 | -0.1 | -0.2 |
| Warpage of the holding member upon a change in the ambient temperature (mm) | 0.05 | -0.03 | -0.05 |

Results of measuring the amounts of warpage of the holding members 102 upon a change in the ambient temperature by heating the circuit boards 101 at a temperature of 200°C are also shown in Table 6. When the thickness of the circuit wiring board 104 was 1.3 mm, the changed amount of the warpage of the holding member 102 was smallest.

When the circuit boards 101 were subjected to the temperature cycle experiment (-45°C to 200°C, 1000 cycles, the 30 boards (10 samples × 3 types) subjected to the temperature cycle experiment), peeling of the bonding portions of all the samples and damage of the members were not observed.

As a result, when the thickness of the circuit wiring board 104 was approximately 1.3 mm, the amount of the warpage was suppressed to a value that was equal to or close to the conventional circuit board 301 (Fig. 6) or less.

### Seventh Embodiment

### (Al base 3 mm/Al wiring)

The present embodiment describes configurations of the circuit board, which are different from the sixth embodiment.

The configuration of the circuit board illustrated in Fig. 1 and the process of forming the circuit board illustrated in Fig. 1 are already described, and a description thereof is omitted.

As the holding member 102, an aluminum plate that has a size of 82 mm × 92 mm and a thickness of 3 mm was used.

As the circuit wiring boards 104, aluminum plates each having outermost ends of 46 mm × 52 mm were used. The circuit wiring boards 104 each have a wiring pattern occupying 86% of the area of the surface of the insulating substrate 103. The copper plates that are of three types and have different thicknesses of 1 mm, 2 mm, and 3 mm were prepared.

The insulating substrate and the bonding layers are the same as the first embodiment, and a description thereof is omitted.

The amounts of warpage of the holding members 102 were measured using the circuit boards 101 obtained through the same formation process as the first embodiment. Results are shown in Table 7. In all samples, the holding members 102 were warped and convex toward the side of the circuit wiring boards 104, and the amounts of the warpage could not be suppressed to 0.1 mm or less.

**[Table 7]**

| | | | |
|---|---|---|---|
| The thickness of the circuit wiring board (mm) | 1 | 2 | 3 |
| Warpage of the holding member after the bonding (mm) | 1.7 | 0.8 | 0.4 |
| Warpage of the holding member upon a change in the ambient temperature (mm) | -0.5 | -0.3 | -0.1 |

Results of measuring the amounts of warpage of the holding members 102 upon a change in the ambient temperature by heating the circuit boards 101 at a temperature of 200°C are also shown in Table 7. In all the samples, the amounts of the warpage, caused by the change in the ambient temperature, of the holding members 102 could not be suppressed to 0.1 mm or less.

When the circuit boards 101 were subjected to the temperature cycle experiment (-45°C to 200°C, 1000 cycles, the 30 boards (10 samples × 3 types) subjected to the temperature cycle experiment), a crack that extends from an end portion of the circuit wiring board was observed on the insulating substrate in each of all samples provided with the circuit wiring boards with the thicknesses of 2 mm and 3 mm.

When the holding member 102 and the circuit wiring board 104 are made of aluminum, differences between the thermal expansion coefficients of the holding member 102 and circuit wiring board 104 and that of the insulating substrate 103 are large, and stress applied to the insulating substrate 103 increases. It was, therefore, necessary to reduce the thicknesses of the holding member 102 and circuit wiring board 104, compared with the case where copper is used.

As a result, when the thickness of the holding member 102 was larger than at least 3 mm, it was difficult to suppress the amount of the warpage to an amount that was equal to or close to the conventional circuit board 301 (Fig. 6) or less.

### Eighth Embodiment

### (Bonding region control using silver oxide sheet)

The present embodiment describes configurations of the circuit board, which are different from the first embodiment.

The configuration of the circuit board illustrated in Fig. 3 and the process of forming the circuit board illustrated in Fig. 3 are described in the first embodiment, and a description thereof is omitted.

As the circuit wiring board 104, a copper plate that has outermost ends of 46 mm × 52 mm and a thickness of 1.3 mm was used.

The holding member and the insulating substrate are the same as the first embodiment, and a description thereof is omitted.

As the bonding material forming the bonding layers 105 and 106, sheet members that are formed by anodizing both surfaces of a silver foil with a thickness of 50 µm and each have silver oxide layers with a thickness of 1.4 µm were prepared. The sheet members each have a size of 46 mm × 52 mm, which are the same as the outermost ends of the circuit wiring board 104. Before the bonding, the sheet members were soaked in a triethylene glycol solution that acts as the reductant.

The sheet members are arranged on the surface, facing the holding member 102, of the insulating substrate 103 having the oxide layers thereon and on the surface, facing the insulating substrate 103, of the circuit wiring board 104. The holding member 102, the insulating substrate 103, and the circuit wiring board 104 were sequentially stacked in this order. In this case, outermost ends of the sheet member arranged on the side of the holding member almost match the outermost ends of the circuit wiring board 104. Then, the circuit board 101 that has the bonding layers 105 and 106 made of sintered bodies with the average thickness of 0.05 mm was obtained by heating in the atmosphere at a temperature of 250°C under pressure of 2.5 MPa for 2 minutes.

When the amount of warpage of the holding member 102 was measured using the obtained circuit board 101, the holding member 102 was warped by 0.03 mm and convex toward the opposite side of the circuit wiring board 104.

In addition, when the circuit board 101 was heated at a temperature of 200°C and the amount of warpage of the holding member 102 upon a change in the ambient temperature was measured, the holding member 102 was warped by 0.02 mm and convex toward the opposite side to the circuit wiring board 104. In other words, the holding member 102 changed by 0.01 mm due to the temperature change of 200°C.

In addition, stress applied to the insulating substrate 103 was evaluated by simulation (thermal stress analysis) using the structure according to the present embodiment. As a result, although stress applied to a corner portion and the surface contacting the circuit wiring board 104 was highest, it suppressed to approximately 80% of the first embodiment. The stress applied to the insulating substrate 103 can be reduced by setting the region in which the bonding layer 106 is formed to be nearly the same as the outermost ends of the bonding layer 105, and whereby the durability of the circuit board 101 can be improved.

When the circuit boards 101 were subjected to the temperature cycle experiment (-45°C to 200°C, 1000 cycles, the 10 samples subjected to the temperature cycle experiment), peeling of the bonding portions of all the samples and damage of the members were not observed. Ninth Embodiment

### (Control of oxidized range of ceramic surface)

The present embodiment describes configurations of the circuit board, which are different from the eighth embodiment.

The configuration of the circuit board illustrated in Fig. 3 and the process of forming the circuit board illustrated in Fig. 3 are already described in the seventh embodiment, and a description thereof is omitted.

The circuit wiring board, the holding member, and the bonding material are the same as the eighth embodiment, and a description thereof is omitted. As the bonding material, sheet members that are formed by anodizing both surfaces of a silver foil with a thickness of 50 µm and each have silver oxide layers with a thickness of 1.4 µm were prepared.

In order to bond the insulating substrate 103 to the bonding layers 105 and 106 with high strength, oxide films were formed on parts of the surfaces of the insulating substrate 103. As the oxide films, silicon dioxide films that are formed by an aerosol deposition method and have a thickness of 200 nm were used. During the formation of the films, masks were placed on the parts of the surfaces of the insulating substrate so that the oxide films were formed only on the regions in which the bonding layers 105 and 106 are formed.

When the amount of warpage of the holding member 102 was measured using the circuit board 101 obtained through the same process as the eighth embodiment, the holding member 102 was warped by 0.05 mm and convex toward the opposite side to the circuit wiring board 104.

In addition, when the circuit board 101 was heated at a temperature of 200°C and the amount of warpage of the holding member 102 upon a change in the ambient temperature was measured, the holding member 102 was warped by 0.02 mm and convex toward the opposite side to the circuit wiring board 104. In other words, the holding member 102 changed by 0.02 mm due to the temperature change of 200°C.

In addition, stress applied to the insulating substrate 103 was evaluated by simulation (thermal stress analysis) using the structure according to the present embodiment. As a result, although stress applied to a corner portion and the surface contacting the circuit wiring board 104 was highest, it suppressed to approximately 80% of the first embodiment. The stress applied to the insulating substrate 103 can be reduced by setting the region in which the bonding layer 106 is formed to be nearly the same as the outermost ends of the bonding layer 105, and whereby the durability of the circuit board 101 can be improved.

When the circuit boards 101 were subjected to the temperature cycle experiment (-45°C to 200°C, 1000 cycles, the 10 samples subjected), peeling of the bonding portions of all the samples and damage of the members were not observed.

### Tenth Embodiment

### (Inclination of end portions of wiring board)

The present embodiment describes configurations of the circuit board, which are different from the second embodiment.

The configuration of the circuit board illustrated in Fig. 1 and the process of forming the circuit board illustrated in Fig. 1 are described in the second embodiment, and a description thereof is omitted.

As the holding member 102, a copper plate that has a size of 82 mm × 92 mm and a thickness of 10 mm was used.

The thickness of the circuit wiring board 104 was 3 mm. Side surfaces of the circuit wiring board 104 were inclined so that the circuit wiring board 104 had a surface contacting the bonding layer 105 and having outermost ends of 46 mm × 52 mm and had a surface opposing the surface contacting the bonding layer and having outermost ends of 48 mm × 54 mm, and whereby an area in which a semiconductor substrate can be mounted was increased.

The insulating substrate and the bonding layers are the same as the second embodiment, and a description thereof is omitted.

When the amount of warpage of the holding member 102 was measured using the circuit board 101 formed through the same procedure as the second embodiment, the holding member 102 was warped and convex toward the side of the circuit wiring board 104. The amount of the warpage of the holding member 102 was approximately 0.1 mm.

In addition, when the circuit board 101 was heated at a temperature of 200°C and the amount of warpage of the holding member 102 upon a change in the ambient temperature was measured, the changed amount of the warpage of the holding member 102 was 0.01 mm.

When the circuit boards 101 were subjected to the temperature cycle experiment (-45°C to 200°C, 1000 cycles, the 10 samples subjected), peeling of the bonding portions of all the samples and damage of the members were not observed.

### Eleventh Embodiment

### (Cu base 0.7 mm/Cu wiring, reinforcing frame)

The present embodiment describes configurations of the circuit board, which are different from the first embodiment.

The configuration of the circuit board illustrated in Fig. 4 and the process of forming the circuit board illustrated in Fig. 4 are described in the first embodiment, and a description thereof is omitted.

As the holding member 102, a copper plate that has a size of 82 mm × 92 mm and a thickness of 0.7 mm was used.

As the circuit wiring board 104, a copper plate that has outermost ends of 46 mm × 52 mm and a thickness of 0.9 mm was used.

The insulating substrate and the bonding layers are the same as the first embodiment, and a description thereof is omitted.

In the present embodiment, a reinforcing frame 110 with a width of 15 mm was attached to an outer circumferential portion of the holding member 102 with the thickness of 0.7 mm. The reinforcing member 110 was made of the same material as the holding member 102. In addition, after the semiconductor substrate and a wiring were attached to the circuit board 101, screw holes 111 that has a diameter of 6.5 mm were formed at four corners so as to extend through the reinforcing member 110 and the holding member 102 in consideration of installation of the circuit board 101 in a power conversion system.

When the amount of warpage of the holding member 102 was measured using the circuit board 101 obtained through the same formation process as the first embodiment, the holding member 102 was warped by 0.05 mm and convex toward the opposite side to the circuit wiring board 104.

In addition, when the circuit board 101 was heated at a temperature of 200°C and the amount of warpage of the holding member 102 upon a change in the ambient temperature was measured, the holding member 102 was warped by 0.02 mm and convex toward the opposite side to the circuit wiring board 104. In other words, the holding member 102 changed by 0.03 mm due to the temperature change of 200°C.

When the circuit boards 101 were subjected to the temperature cycle experiment (-45°C to 200°C, 1000 cycles, the 10 samples subjected), peeling of the bonding portions of all the samples and damage of the members were not observed.

### Twelfth Embodiment

### (Partial plating)

The present embodiment describes the configuration of a semiconductor module substrate that uses the circuit board formed in the eleventh embodiment.

The configuration of the circuit board illustrated in Fig. 4 and the process of forming the circuit board illustrated in Fig. 4 are described in the eleventh embodiment, and a description thereof is omitted.

As the holding member 102, a copper plate that has a size of 82 mm × 92 mm and a thickness of 0.7 mm was used. A silver-plated layer that has a thickness of approximately 4 µm was formed on the surface contacting the bonding layer 106.

As the circuit wiring board 104, a copper plate that has outermost ends of 46 mm × 52 mm and a thickness of 0.9 mm was used. A silver-plated layer that has a thickness of approximately 4 µm was formed on the surface contacting the bonding layer 105. In addition, a nickel-plated layer that has a thickness of 6 µm was formed on the surface opposing the bonding layer 105 in a region in which the semiconductor substrate was bonded through solder, while a silver-plated layer that has a thickness of approximately 4 µm was formed on the surface opposing the bonding layer 105 in a region in which a wiring was bonded. Copper was exposed on the surface in a region in which the plated layers were not formed.

The insulating substrate and the bonding layers are the same as the eleventh embodiment, and a description thereof is omitted.

When the amount of warpage of the holding member 102 was measured using the circuit board 101 obtained through the same formation process as the eleventh embodiment, the holding member 102 was warped by 0.05 mm and convex toward the opposite side to the circuit wiring board 104.

In addition, when the circuit board 101 was heated at a temperature of 200°C and the amount of warpage of the holding member 102 upon a change in the ambient temperature was measured, the holding member 102 was warped by 0.02 mm and convex toward the opposite side to the circuit wiring board 104. In other words, the holding member 102 changed by 0.03 mm due to the temperature change of 200°C.

When the circuit boards 101 were subjected to the temperature cycle experiment (-45°C to 200°C, 1000 cycles, the 10 samples subjected), peeling of the bonding portions of all the samples and damage of the members were not observed.

### Thirteenth Embodiment

### (Board for module)

The present embodiment describes the configuration of a board that is provided for a semiconductor module and uses the circuit board formed in the twelfth embodiment.

Fig. 5 is a diagram illustrating the configuration of a circuit board 201 for a semiconductor module according to the twelfth embodiment.

Six power semiconductor substrates 210 were arranged on the circuit board composed of a holding member 202, an insulating substrate 203, and a circuit wiring board 204. The power semiconductor substrates 210 were bonded to the circuit board 201 using a bonding material containing a silver oxide. The circuit board 201 for a semiconductor module was configured by connecting electrodes formed on the top surfaces of the power semiconductor substrates 210 to a predetermined wiring on the circuit board 201 through a wire (not illustrated) made of aluminum and attaching an input and output terminal (not illustrated) made of copper from a predetermined position of the circuit board 201. A semiconductor module was formed by connecting the semiconductor module circuit boards 201 in parallel so as to cause the circuit boards 201 to operate with a desired voltage and current.

When the formed semiconductor module circuit boards 201 were subjected to the temperature cycle experiment (-45°C to 200°C, 1000 cycles, the 10 samples subjected), peeling of the bonding portions of all the samples and damage of the members were not observed. In addition, a change in electric characteristics and heat-transfer characteristics was not observed.

### Description of Reference Numerals

- 101, 201, 301: Circuit board
- 102, 202, 302: Holding member
- 103, 203, 303: Insulating substrate
- 104, 204, 304, 305: Circuit wiring board
- 105, 106, 306, 307: Bonding layer
- 107, 108: Oxide layer
- 110: Reinforcing member
- 111: Through hole
- 210: Semiconductor element
- 308: Solder layer

## Claims

1. A circuit board comprising a holding member, a bonding layer, an insulating substrate, a bonding layer, and a circuit wiring board, which are sequentially stacked in this order,
wherein the bonding layers are sintered bodies containing metal, the insulating substrate is made of non-oxide ceramic, and oxide layers are formed on both surfaces of the insulating substrate.

2. The circuit board according to claim 1,
wherein the bonding layers are made of silver or a composite material containing silver, and a bonding temperature is in a range of 180°C to 400°C.

3. The circuit board according to claim 1,
wherein the thicknesses of the bonding layers are in a range of 10 µm to 200 µm.

4. The circuit board according to claim 1,
wherein the oxide layers have a thickness of 0.1 nm to 300 nm and are formed in 50% or more of regions in which the bonding layers are formed.

5. The circuit board according to claim 1,
wherein the insulating substrate has a thermal expansion coefficient of 10 × 10⁻⁶/°C or lower at a temperature of -50°C to 200°C and deflective strength of 300 MPa or higher.

6. The circuit board according to claim 1,
wherein the insulating substrate is made of a nitride.

7. The circuit board according to claim 6,
wherein the insulating substrate is made of a nitride containing silicon.

8. The circuit board according to claim 1,
wherein the holding member has a thermal expansion coefficient of 10 × 10⁻⁶/°C to 20 × 10⁻⁶/°C at a temperature of -50°C to 200°C, the thickness of the holding member is in a range of 0.5 mm to 20 mm in the regions in which the bonding layers are formed, and the thickness of the circuit wiring board is in a range of 0.5 mm to 3 mm.

9. The circuit board according to claim 8,
wherein the holding member is made of copper or an alloy containing copper.

10. The circuit board according to claim 1,
wherein the holding member and the circuit wiring board have a thermal expansion coefficient of 20 × 10⁻⁶/°C to 30 × 10⁻⁶/°C at a temperature of -50°C to 200°C, the thickness of the holding member is in a range of 0.5 mm to 2 mm in the regions in which the bonding layers are formed, and the thickness of the circuit wiring board is larger than the holding member and 3 mm or less.

11. The circuit board according to claim 10,
wherein the holding member and the circuit wiring board are made of aluminum or an alloy containing aluminum.

12. The circuit board according to claim 1,
wherein the region in which the bonding layer is formed between a metal plate for heat dissipation and the insulating substrate is narrower than an end portion of the metal plate for heat dissipation and wider than a region that is narrower by 1 mm than an outermost end of the bonding layer formed between the circuit wiring board and the insulating substrate.

13. The circuit board according to claim 1,
wherein an area in which the circuit wiring board is formed is in a range of 70% to 95% of the area of the insulating substrate.

14. The circuit board according to claim 1,
wherein a plated layer made of a different material from the holding member or the circuit wiring board is formed on a part of the holding member or a part of the circuit wiring board.

15. The circuit board according to claim 1,
wherein the area of a surface, contacting the bonding layer, of the circuit wiring board is smaller than the area of an opposing surface of the circuit wiring board.
